# EUROPÄISCHE PATENTSCHRIFT

(11) **EP 4 484 899 B1**
(45) Veröffentlichungstag und Bekanntmachung des Hinweises auf die Patenterteilung: **27.05.2026**
(21) Anmeldenummer: 24184568.4
(22) Anmeldetag: 26.06.2024
(51) Int. Cl.: G01D 11/24

(54) **ELEKTRONISCHE BAUGRUPPE SOWIE VERFAHREN ZUR HERSTELLUNG EINER ELEKTRONISCHEN BAUGRUPPE**
ELECTRONIC ASSEMBLY AND METHOD FOR PRODUCING AN ELECTRONIC ASSEMBLY
MODULE ÉLECTRONIQUE ET PROCÉDÉ DE FABRICATION D'UN MODULE ÉLECTRONIQUE

(30) Priorität: 30.06.2023 DE 102023117285
(43) Veröffentlichungstag der Anmeldung: 01.01.2025
(73) Patentinhaber: Turck Holding GmbH, 58553 Halver (DE)
(72) Erfinder: Unger, Kay, 08315 Lauter-Bernsbach (DE); Leonhardt, Christian, 09111 Chemnitz (DE); Kiesel, Jan, 59439 Holzwickede (DE)
(74) Vertreter: DTS Patent- und Rechtsanwälte PartmbB

(56) Entgegenhaltungen:
- EP-B1- 0 779 500
- DE-A1- 102015 103 551
- DE-A1- 3 325 462

## Beschreibung

Die vorliegende Erfindung betrifft eine elektronische Baugruppe sowie ein Verfahren zur Herstellung einer solchen elektronischen Baugruppe. Ein Beispiel einer solchen elektronischen Baugruppe kann ein Näherungsschalter oder jegliches andere elektronische Schaltgerät sein.

Ein elektronisches Schaltgerät aus dem Stand der Technik, wie es in der DE 10 2017 201 320 B3 offenbart ist, ist in Fig. 5 gezeigt. Dieses weist ein Gehäuse mit einem zylindrischen Abschnitt 5 auf. In diesem zylindrischen Abschnitt 5 sind ein Schaltungsträger 2 sowie eine Sensoreinheit 1 untergebracht. Die Sensoreinheit 1 ist in diesem Anwendungsbeispiel aus dem Stand der Technik in Form einer gewickelten Frontspule ausgeführt. Die Sensoreinheit definiert eine Frontseite des elektronischen Schaltgeräts, wobei der Stecker 3 eine Rückseite des elektronischen Schaltgeräts definiert.

Um eine Abdichtung der elektronischen Bauteile im Inneren des Gehäuses zu erreichen, wird in der DE 10 2017 201 320 B3 eine Situation beschrieben, in der der Stecker 3 von der Rückseite in das Gehäuse eingeschoben wird und das Gewinderohr 6 mit einer Lochscheibe 7 und dem zylindrischen Abschnitt 5 verbördelt werden. Im Inneren des elektronischen Schaltgeräts ist ein PU-Weichschaum 4 aus Weichschaum vorgesehen, sodass eine Dichtigkeit erreicht wird. Die DE 102017 201 320 B3 grenzt sich so vom Stand der Technik ab, dass eben dieser Weichschaum anstelle eines Epoxidharzes verwendet wird, bei dem es angeblich zu einer ungünstigen Abdichtung kommt.

Weiterer relevanter Stand der Technik ist in der DE 10 2017 129 687 B4, der EP 1 695 037 B1, der EP 0 779 500 B1, der DE 10 2015 103 551 und der A1DE 33 25 462 A1beschrieben. In der EP 1 695 037 B1 ist ein Beispiel eines Aufbaus eines Schaltgerätes mit Schirmhülse zur Abschirmung von elektromagnetischer Strahlung beschrieben.

Ausgehend von dem oben genannten Stand der Technik, ist es die Aufgabe der vorliegenden Erfindung, ein vereinfachtes Verfahren insbesondere zur automatisierten Herstellung einer elektronischen Baugruppe beziehungsweise eine kostengünstig herzustellende elektronische Baugruppe anzugeben.

Zur Lösung des Problems werden gemäß den anliegenden unabhängigen Ansprüchen eine elektronische Baugruppe sowie ein Verfahren zur Herstellung einer elektronischen Baugruppe vorgeschlagen.

Die elektronische Baugruppe weist ein Gehäuse, einen Stecker, eine Elektronikplatine, eine Sensorplatine und eine Frontkappe auf. Das Gehäuse kann eine zylindrische und insbesondere rohrförmige Ausgestaltung haben. Es ist auch jede andere Gehäuseform möglich. Das Gehäuse hat üblicherweise eine axiale Erstreckung entlang einer Erstreckungsrichtung von einer Frontseite zu einer Rückseite. Das Gehäuse nimmt von der Rückseite zu einer Frontseite hin nacheinander den Stecker, die Elektronikplatine, die Sensorplatine und die Frontkappe auf.

Der Stecker kann als separates Element hergestellt werden und weist zum Beispiel ein Steckergehäuse auf, in dem ein oder mehrere Pins vorgesehen sind, welche die Steckerfunktionalität gewährleisten.

Der Stecker kontaktiert zum Beispiel ein erstes Ende der Elektronikplatine. Die Elektronikplatine kann zum Beispiel ein planares Element mit darauf montierten Elektronikbausteinen sein. An einem zweiten Ende der Elektronikplatine kann dann eine Sensorplatine entsprechend mit der Elektronikplatine kontaktiert sein.

Der Stecker, die Elektronikplatine und die Sensorplatine bilden eine zusammengesetzte Baueinheit. Eine zusammengesetzte Baueinheit ist eine Baueinheit, bei der die Elektronikplatine und die Sensorplatine beispielsweise durch Verlöten und/oder durch zusätzliches Umspritzen, beispielsweise mittels Hotmelt-Verfahren miteinander verbunden werden und so eine zusammengesetzte Baueinheit bilden. Diese Baueinheit kann dann von der Frontseite her als Ganzes in das Gehäuse eingeschoben werden.

Nach dem Einschieben dieser zusammengesetzten Baueinheit wechselwirkt eine axiale Endfläche des Steckers mit einem Bund, der an der Rückseite des Gehäuses vorgesehen ist, sodass der Stecker nicht aus der Rückseite des Gehäuses herausgezogen werden kann.

Die Frontseite des Gehäuses ist mittels Bördeln um die Frontkappe geschlossen und/oder abgedichtet, sodass die Baueinheit in dem Gehäuse fixiert ist und gegen den Bund gedrückt wird.

So ist ein einfaches Herstellen der elektronischen Baugruppe möglich und ein Austausch von einzelnen Teilen ist auch gewährleistet.

Gemäß einer Weiterbildung der Erfindung weist der Stecker das Steckergehäuse und Steckerpins auf. Die Steckerpins sind in dem Steckergehäuse gehalten. Das rückseitige Ende der Pins, mittels welchem eine Kontaktierung mit dem ersten Ende der Elektronikplatine vorliegt, ist vorzugsweise sichelförmig ausgestaltet. Auch wenn vorliegend die Mehrzahl "Pins" beschrieben wird, kann auch lediglich ein einziger Pin vorgesehen sein, der die Steckerfunktionalität bildet.

Die sichelförmige oder auch bananenförmige Ausgestaltung in Verbindung mit den Kontaktierungspads auf der Platine, an denen die Pins einen Kontakt zu der Elektronikplatinen herstellen, ist besonders günstig, um eine einfache Kontaktierung und Fixierung zu ermöglichen.

Insbesondere sind die Pins jeweils so in dem Steckergehäuse angeordnet, dass sich die sichelförmigen Elemente einander gegenüberliegen sodass sie nach Art von Krallen die Elektronikplatine an den entsprechenden Kontaktierungspads zwischen sich auflegen und diese schon vorfixieren, bevor sie dann, wie später beschrieben, mittels Löten, insbesondere in einem selektiven Lötprozess mit den Kontaktierungspads verbunden werden.

Die Pins können aus einem Vollmaterial gezogen sein. Dieses ermöglicht eine stabilere Ausgestaltung und eine mechanisch weniger anfällige Verbindung.

Insbesondere sind die Pins beispielsweise aus Messing hergestellt. Es kann aber auch jedes andere leitende Material, insbesondere Metallmaterial, verwendet werden.

Gemäß einer Weiterbildung der Erfindung kann ein Erdungselement vorgesehen sein, welches zwischen der Elektronikplatine und dem Gehäuse an einem elektronikplatinenseitigen Ende des Steckergehäuses vorgesehen ist. Das Erdungselement ist insbesondere aus Metall hergestellt. Jedes andere elektrisch leitende Material kann aber auch Verwendung finden. Das Gehäuse ist vorzugsweise ebenso aus einem elektrisch leitenden Material, z.B. Metall, hergestellt.

Das Erdungselement kann durch einen Blechring gebildet sein, der zumindest eine Lötfahne zur Kontaktierung eines Massekontaktpads der Elektronikplatine aufweist, welches Kontaktpad mit einem Kondensator auf der Elektronikplatine verbunden ist. Zusätzlich kann der Blechring zumindest eine davon abstehende Einpressfahne aufweist, die eine elektrisch leitende Kontaktierung zum Gehäuse herstellt. Insbesondere sind genau zwei Lötfahnen vorgesehen, die die Elektronikplatine zwischen sich aufnehmen. Günstig ist es, wenn zudem vier Einpressfahnen an dem Blechring vorgesehen sind. Die Einpressfahne ist z.B. eine lokale radiale Verbreiterung des Ringes.

Gemäß einer vorteilhaften Weiterbildung der Erfindung ist die zusammengesetzte Baueinheit zumindest teilweise von einer gespritzten Hülle umgeben.

Beispielsweise können die Elektronikplatine und die Sensorplatine von der gespritzten Hülle umgeben sein und die Umspritzung kann bis zum Stecker reichen, sodass eine zusätzliche Verbindung zwischen den Platinen und dem Stecker erhalten wird. Die gespritzte Hülle kann mittels Niederdruckspritzgussverfahrens hergestellt sein und so bildet die Baueinheit eine unverlierbare und integrale Einheit und diese Baueinheit mit ihrer gespritzten Hülle wird in das Gehäuse eingesetzt.

Um die Funktionsfähigkeit von empfindlichen elektronischen Bauteilen wie Platinen, Sensoren oder anderen elektronischen Komponenten zu gewährleisten, ist es entscheidend, dass diese vor negativen Umwelteinflüssen geschützt werden. Hierbei kommt zum Beispiel das Niederdruckspritzgussverfahren zum Einsatz, welches eine effektive Abdichtung von elektronischen Bauteilen ermöglicht.

Durch die Verwendung verschiedener Materialien können individuelle Anforderungen hinsichtlich Flexibilität, Schlagfestigkeit, Stoßdämpfung, Feuchtigkeitsbeständigkeit, Dichtigkeit, UV-Schutz, Chemikalienresistenz und Farbe berücksichtigt werden. Dies sorgt für eine optimale Anpassung an die spezifischen Anforderungen der jeweiligen Bauteile.

Mit dem Niederdruck-Spritzgussverfahren werden die Bauteile in eine Form gelegt und direkt mit dem Schmelzklebstoff umhüllt. Hierbei wird ein Einspritzdruck von 1,5 bis 40 bar und ein Einsatz-Temperaturbereich von -50° bis +200°C verwendet. Durch diese Vergusstechnik können nicht nur die Bauteile vor Korrosion und Umwelteinflüssen geschützt werden, sondern es können auch Bohrungen und Schraubgewinde integriert werden, um eine weiter verbesserte Funktionalität zu gewährleisten.

Die Kontur der gespritzten Hülle kann einer Innenkontur des Gehäuses entsprechen, soweit es sich somit um ein Gehäuse mit rohrförmigem Querschnitt handelt, hat auch diese gespritzte Hülle eine Tubusform. Die Kontur der gespritzten Hülle berücksichtigt jedoch z:B. die Temperaturausdehnungskoeffizienten des thermoplastischen Kunststoffes und lässt einen definierten Pufferbereich für die Wärmeausdehnung zum Gehäuse frei. Die Baueinheit mit der gespritzten Hülle wird so lediglich durch die gebördelte Seite des Gehäuses an der Front und den Bund an der Rückseite gehalten und somit kann die elektronische Baugruppe auch leichter wieder auseinandergebaut werden. Die Verwendung von thermoplastischem Kunststoff ermöglicht auch durch seine geringe Adhäsionskraft im Vergleich zu typischen Vergussmassen, insbesondere basierend auf duroplastischen oder elastomeren Kunststoffmassen, etwa Epoxidharze beziehungsweise duroplastische Kunststoffmassen oder Silikonmassen beziehungsweise elastomere Kunststoffmassen, ein nachträgliches mechanisches Entfernen des Kunststoffes, weshalb Reparaturarbeiten an der Platine oder auch ein Recycling der Einzelkomponenten ermöglicht wird.

Die gespritzte Hülle kann integral daran eine Dichtlippe aufweisen, beispielsweise, sollte die gespritzte Hülle tubusförmig ausgebildet sein, kann die Dichtlippe umlaufend um den Tubus sein, um eine wasserdichte Abdichtung zur Innenwand des Gehäuses zu gewährleisten.

Die obenstehend sehr allgemein beschriebene elektronische Baugruppe kann zum Beispiel von einem Näherungsschalter oder von jedem anderen elektronischen Schalter gebildet werden oder einen solchen umfassen. Weitere Sensortypen sind folgende: induktiver Sensor, kapazitiver Sensor, Drucksensor, Gassensor, Temperatursensor, Feuchtigkeitssensor, Ultraschallsensor, Vibrationserkennungssensor, UV-sensor.

Ferner wird ein Verfahren zur Herstellung einer elektronischen Baugruppe angegeben. Die Baugruppe kann eine zuvor genannte Baugruppe sein.

Auch die nachfolgend für das Verfahren angegebenen Verfahrensmerkmale können in vorrichtungsmäßiger Form bei der elektronischen Baugruppe vorgesehen sein.

Bei dem Verfahren werden zunächst die rückseitigen Enden von Pins des Steckers mit einem ersten Ende der Elektronikplatine kontaktiert. Es werden zudem die Kontakte der Sensorplatine mit den entsprechenden Kontakten der Elektronikplatine an dem zweiten Ende der Elektronikplatine kontaktiert. Somit bildet der Stecker der Elektronikplatine die Sensorplatine als zusammengesetzte Baueinheit. Die beiden zuvor genannten Kontaktierungsschritte können ohne weiteres auch in der umgekehrten Reihenfolge durchgeführt werden.

Die zusammengesetzte Baueinheit kann dann vorteilhafterweise integral die gespritzte Hülle aufweisen, die insbesondere mittels des Niederdruckspritzgussverfahrens hergestellt wird.

Die Baueinheit wird dann in das Gehäuse von der Frontseite zu einer Rückseite eingeführt, bis sich eine axiale Endfläche des Steckers an dem Bund an der Rückseite des Gehäuses abstützt. Ferner wird das Gehäuse an der Frontseite mit der Kappe verschlossen und die Rückseite des Gehäuses um die Frontkappe wird gebördelt, sodass sich die Baueinheit im Gehäuse fixiert und gegen den Bund gedrückt wird.

Die Kappe kann auch schon auf der Frontseite der Baueinheit vorgesehen sein beziehungsweise montiert werden bevor diese in das Gehäuse eingesteckt wird und muss dann nicht erst nach dem Einstecken der Baueinheit angebracht werden.

Gemäß einer vorteilhaften Weiterbildung der Erfindung kann das Verfahren des Weiteren die Schritte des Umspritzens von zumindest Teilen der Baueinheit aufweisen, sodass die Baueinheit zumindest teilweise von einer gespritzten Hülle umgeben wird. Beispielsweise kann die Umspritzung bis zum Stecker reichen, sodass die weiteren Elemente der Baueinheit besser mit dem Stecker verbunden sind.

Die gespritzte Hülle ist vorteilhafterweise aus einem thermoplastischen Kunststoff hergestellt. Die Kontur der gespritzten Hülle berücksichtigt beispielsweise die Temperaturausdehnungskoeffizienten des thermoplastischen Kunststoffes und lässt einen definierten Pufferbereich für die Wärmeausdehnung zum Gehäuse frei.

Die gespritzte Hülle kann mittels des zuvor genannten Niederdruckspritzgussverfahrens hergestellt werden.

Das Kontaktieren der Rückseitenenden der Pins des Steckers mit den ersten Enden der Platine und alternativ oder zusätzlich das Kontaktieren der Kontakte der Sensorplatte mit den entsprechenden Kontakten der Elektronikplatine und dem zweiten Ende der Elektronikplatine kann mittels eines Selektivlötprozesses erfolgen.

Selektivlöten ersetzt in der Baugruppenfertigung - vereinfacht gesagt - das Löten mit der Hand. Es ist ein automatisiertes 3D-Lötverfahren, das über eine Software gesteuert wird. Dabei werden X-, Y- und Z-Koordinaten auf der Platine festgelegt. Die Koordinaten kennzeichnen, an welchen Stellen auf der Leiterplatte das heiße Lötzinn abgesetzt wird, um ganz bestimmte Bauteile zu löten. Beispielsweise fährt eine kegelförmige Düse von unten an die Platine heran und setzt punktuell den Lötpunkt. Der Prozess des Selektivlötens wird zum Beispiel auch als Video aufgezeichnet.

Es kann auch eine selektive Lötung über eine Miniwelle erfolgen. Besonders bei einer größeren Anzahl von Lötstellen bietet sich das Selektivlöten mit Miniwelle an. Miniwellen können bereits ab einem Freiraum von 2 mm um den Lötbereich herum eingesetzt werden. Durch schnellwechselbare Düsensätze ist das Verfahren flexibel einsetzbar für unterschiedlichste Lötstellen.

Das Selektivlötverfahren leiten sich vom Wellenlöten ab, bei dem durch die Verkleinerung der Lötwelle beziehungsweise Reduzierung des Lötbades auf kleine Lötdüsen der Lötbereich eingeschränkt wurde.

Bei dem Verfahren wird das Werkstück in eine "stehende" Miniwelle getaucht. Um die entstehende Oxidhaut an der Oberfläche abzureißen, fließt die Lotwelle innerhalb der Düse, das heißt intern, ab. Um die Oxidbildung am Düsenaustritt zu reduzieren und die Lötung zu verbessern, wird die Düse zum Beispiel mit Stickstoff umspült.

Mit einer einzigen Welle können so zum Beispiel die Kontaktierungen an dem ersten und/oder zweiten Ende der Elektronikplatine hergestellt werden. Alle Kontakte zwischen Sensorplatine und Elektronikplatine beziehungsweise zwischen Pins und Elektronikplatine können so in einem Verfahrenszug bzw. zwei Selektivlötverfahrensschritten, einen für das sensorseitige Ende und einen für das steckerseitige Ende, hergestellt werden, wenn zum Beispiel die Welle in einem Zug über den Kontaktierungsberiech gefahren wird.

Das zuvor beschriebene Verfahren kann automatisiert durchgeführt werden und die einzelnen Schritte werden insbesondere nicht manuell durchgeführt.

Weitere vorteilhafte Ausgestaltungen werden anhand der nachfolgend beschriebenen Ausführungsform in Verbindung mit den Figuren diskutiert.

Dabei zeigen:
- Fig. 1a: eine Ausgestaltung einer erfindungsgemäßen elektronischen Baugruppe in deren Fügerichtung, in denen die Einzelteile gefügt werden;
- Fig. 1b: eine Seitenansicht mit einer Baueinheit aus Stecker, Elektronikplatine und Sensorplatine, wobei auf der Frontseite bereits die Frontkappe vorgesehen ist;
- Fig. 1c: eine in das Gehäuse eingesetzte Baueinheit aus Fig. 1b in deren Querschnittsansicht;
- Fig. 2a: eine Seitenansicht des Steckergehäuses und der mit diesem verbundene Elektronikplatine,
- Fig. 2b: die entsprechende Seitenansicht des Steckergehäuses aus Figur 2a ohne die montierte Elektronikplatine (vgl. Ansicht in Richtung des Pfeils B in Fig. 2c),
- Fig. 2c: eine schräge Aufsicht auf das Steckergehäuse,
- Fig. 3a: die im Vergleich zu der Ansicht aus Figur 2b um 90 Grad versetzte weitere Seitenansicht des Steckergehäuses (vgl. Ansicht in Richtung des Pfeils D in Fig. 2c),
- Fig. 3b: eine Ansicht von der zu der Elektronikplatine gerichteten Seite des Steckergehäuses,
- Fig. 3c: eine schematische Ansicht, wie das Steckergehäuse mit der daran montierten Elektronikplatine in dem Gehäuse 100 gehalten wird,
- Fig. 4a: eine Aufsicht aus Richtung des Pfeils D in Fig. 2c auf das Arrangement aus Steckergehäuse und damit verbundener Elektronikplatine,
- Fig. 4b: einen Abschnitt der Elektronikplatine mit deren Ende, welches an die Sensorplatine angebunden ist,
- Fig. 4c: eine schräge Ansicht des Verbindungsbereiches zwischen der Elektronikplatine und der Sensorplatine,
- Fig. 4d: eine Seitenansicht des Arrangements aus Fig. 4b,
- Fig. 4e: eine Skizze der Verbindung zwischen den Kontakten der Sensorplatine und den entsprechenden Kontakten der Elektronikplatine, sowie

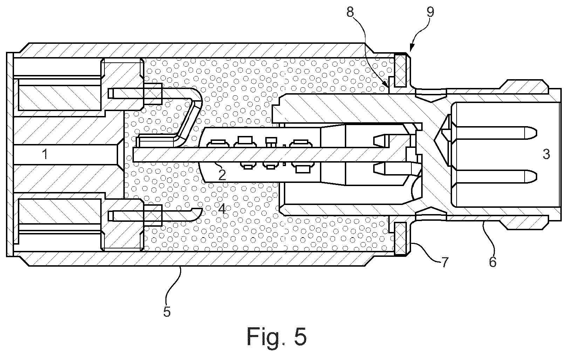

- Fig. 5: eine Baueinheit, wie sie in der DE 10 2017 201 320 B3 beschrieben wird.

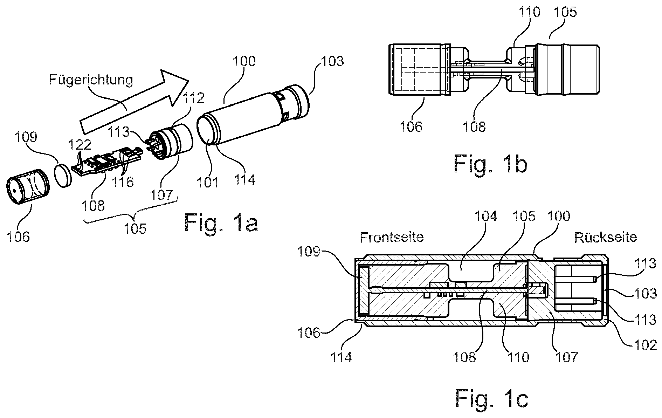

Fig. 1a zeigt mit Bezugszeichen 100 ein Gehäuse.

Dieses ist im vorliegenden Fall zylindrisch, nämlich rohrförmig, ausgebildet. Das Gehäuse 100 hat somit eine axiale Richtung.

Das Gehäuse 100 weist an seiner Frontseite eine Frontöffnung 101 auf.

An einer Rückseite des Gehäuses 100, wie in Fig. 1c zu sehen, ist ein Bund 102 vorgesehen, der durch ein nach innen umgebogenes Ende des Gehäuses 100 gebildet ist.

Das Gehäuse 100 weist an der Rückseite jedenfalls auch eine Rückseitenöffnung 103 auf, deren Querschnitt kleiner ist als die Frontseitenöffnung 101.

Wie aus der Querschnittsansicht in Fig. 1c zu sehen, weist das Gehäuse innen eine zylinderförmige Innenumfangsfläche 104 auf.

Eine Baueinheit 105, die nachfolgend beschrieben ist, wird in die Frontöffnung 101 in das Gehäuse eingefügt.

Dann wird, was in der Querschnittansicht in Fig. 1c nicht zu sehen ist, das Gehäuse an dessen Frontendseite gebördelt und so zumindest teilweise um die Kante der einer Frontkappe 106 gelegt, sodass die Baueinheit 105 in dem Gehäuse fixiert gehalten wird und eine axiale Endfläche des Steckers 107 mit dem Bund 102 wechselwirkt. Dabei stützt sich insbesondere eine axiale Endfläche des Steckers 107 an dem Bund 102 in axialer Richtung ab.

In Fig. 1a sind weitere Teile der elektronischen Baugruppe zu sehen.

Diese sind der Stecker 107, die Elektronikplatine 108 und die Sensorplatine 109.

Die Frontkappe 106 wird bei dem Beispiel nicht als Teil der Baueinheit 105 gesehen, sondern als separates Element betrachtet.

Der Stecker 107, die Elektronikplatine 108 und die Sensorplatine 109 sind über nachfolgendes Löten, zum Beispiel in dem vorliegenden Fall über ein Selektivlöten, miteinander verbunden.

Die bei dem Beispiel vorgesehenen Elemente Stecker 107, Elektronikplatine 108, und Sensorplatine 109 bilden die Baueinheit 105. Diese ist in Fig. 1b in einer Seitenansicht dargestellt.

Die Baueinheit 105 wird, was in Fig. 1a nicht zu sehen ist, von einer gespritzten Hülle 110 umgeben. Diese gespritzte Hülle 110 kann mittels eines Niederdruckspritzgussverfahrens hergestellt sein.

In dem vorliegenden Ausführungsbeispiel hat die gespritzte Hülle 110 an einer zweiten Seite, die an der Frontseite des Gehäuses 100 liegt, sowie an einer ersten Seite, die an einer Rückseite des Gehäuses 100 liegt, eine Verdickung. Dort wird zum Beispiel jeweils eine so genannte Dichtlippe hergestellt.

Diese Dichtlippen stützen sich insbesondere an der Innenwandung des Gehäuses 100 ab, um dieses abzudichten.

Im Bereich der Elektronikplatine, wo eine in den Figuren nicht näher dargestellte Diode vorgesehen sein kann, kann die gespritzte Hülle 110 dünner sein und/oder eine Öffnung aufweisen.

Durch das Überspritzen, insbesondere im Niederdruckspritzgussverfahren, kann eine unverlierbare Baueinheit hergestellt werden, die dann passgenau ins Innere des Gehäuses 100 eingesetzt werden kann.

Der Stecker weist ein Steckergehäuse 112 und darin aufgenommene Pins 113 auf.

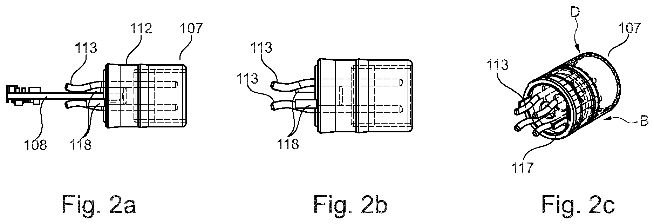

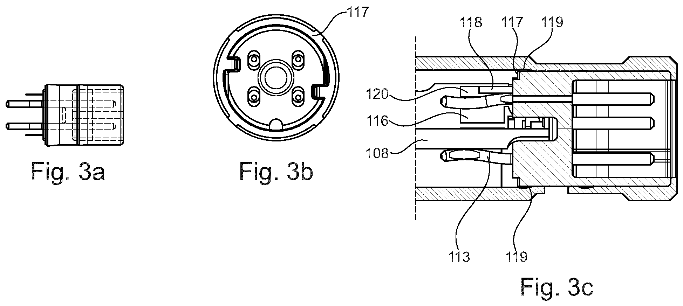

Die Pins 113 haben jeweils an derjenigen Seite, mit welcher die Elektronikplatine 108 kontaktiert wird, eine sichelförmige Ausgestaltung und sind im vorliegenden Beispiel aus einem Vollmaterial gezogen hergestellt. Wie in den Figuren 2c und 3b zu erkennen, sind vorliegend vier solcher Pins 113 vorgesehen.

Neben dem im vorliegenden Ausführungsbeispiel angegebenen 4-Pin-Stecker sind natürlich in analoger Weise auch 3-Pin-Stecker oder Stecker mit mehr als vier Pins denkbar.

Der Querschnitt der Pins 113 ist zumindest an derjenigen Seite, auf der die Elektronikplatine 108 liegt, im Wesentlichen rund oder oval ausgebildet. Vorliegend sind die Pins in deren Querschnitt auf deren gesamten Länge rund ausgebildet.

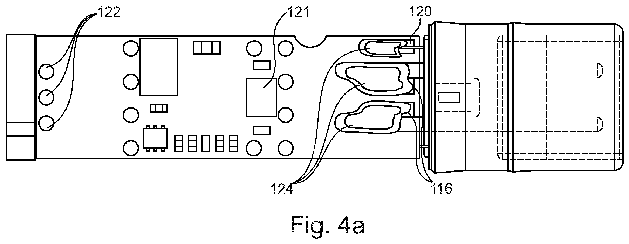

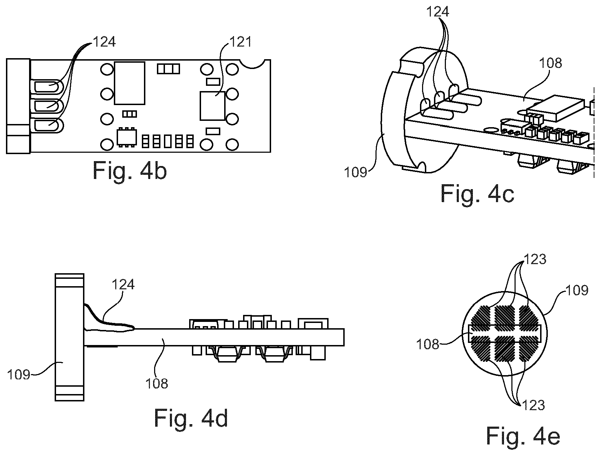

Von einem frontseitigen Ende aus gesehen sind die Pins 113 in einem rückwärtigen Abschnitt gebogen ausgeführt. Jeweils zwei einander gegenüberliegende Pins 113 nehmen, wie in Fig. 2a und 3c zu sehen, die Elektronikplatine zwischen sich auf und kontaktieren die in Fig. 4 an der Elektronikplatine 108 vorgesehenen steckerseitigen Kontaktierungspads 116. Die Biegung der Pins ist bananenförmig wobei die elektronikplatinenseitigen Enden der Pins 113 leicht in radialer Richtung von der Elektronikplatine 108 weg zeigen. Zwei gegenüberliegende Bäuche der bananenförmigen Biegung der Pins 113 bilden einen kürzesten Zwischenraum zwischen den beiden gegenüberliegenden Pins und nehmen dort z.B. die Elektronikplatine 108 zwischen sich auf, insbesondere mit Vorspannung.

Zusätzlich zu den Pins 113 weist der Stecker noch einen Blechring 117 mit zwei Lötfahnen 118 auf (vgl. Fig. 2c, Fig. 3b und c). Der Blechring 117 weist zudem noch in radialer Richtung davon abragende Einpressfahnen 119 auf. Der Blechring 117 ist an dem elektronikplatinenseitigen Ende des Steckergehäuses 112 in axialer Richtung der Baueinheit 105 an dem Steckergehäuse 112 montiert. Das Steckergehäuse 112 mit den Pins 113 und dem Blechring kann somit für sich eine Einheit bilden, die dann zum Beispiel beim automatischen Herstellen der Baueinheit 105 bzw. der gesamten elektronischen Baugruppe schon vorgefertigt verwendet werden kann.

Die Lötfahnen 118 und die Einpressfahnen 119 sind integral an dem Blechring 117 vorgesehen, der als Stanzteil hergestellt werden kann. Auch wenn vorliegend zwei Lötfahnen 118 und vier Einpressfahnen 119 vorgesehen sind, ist die Erdung der Elektronikplatine 108 über das Gehäuse 100 nicht über die spezielle Ausgestaltung und/oder Anzahl der Lötfahnen 118 und Einpressfahnen 119 nötig. Der Blechring 117 ist ein Beispiel eines Erdungselementes, welches zwischen der Elektronikplatine 108 und dem Gehäuse 100 an dem elektronikplatinenseitigen Ende des Steckergehäuses 112 vorgesehen ist.

Vorliegend sind die Lötfahnen 118 als plattenartige Laschen ausgebildet, deren Plattenoberfläche senkrecht zu der Elektronikplatine 108 steht. Auf der Elektronikplatine 108 sind neben den steckerseitigen Kontaktierungspads 116 noch weitere Massekontaktierungspads 120 vorgesehen, die einen Kontakt zu einem auf der Elektronikplatine montieren Kondensator 121 herstellen (vgl. Fig. 4a, Fig. 3c). Vorliegend hat die Elektronikplatine 108 auf jeder der Unter- und Oberseite ein einziges Massekontaktierungspad 120 und zwei steckerseitige Kontaktierungspads 116, entsprechend der Anzahl und Position der Pins 113 und Lötfahnen 118. Die Seitenkanten der zwei Lötfahnen 118 nehmen die Elektronikplatine 108 zwischen sich auf und stabilisieren die Anordnung.

Die in der eingangs erwähnten EP 1 695 037 B1 beschriebene Schirmhülse wird z.B. vorliegend durch die kapazitive Anbindung über das Metallblech (Blechring 117) am Stecker, welches eine leitende Gehäuseverbindung herstellt und auf die Elektronikplatine gelötet, wodurch über einen Kondensator, der auf Schaltungsmasse (GND) gelegt ist, AC-Störungen über das Gehäuse abgeleitet werden können. Vorteilhaft ist daran, dass keine zusätzliche Schirmhülse benötigt wird, sowie kein zusätzlicher Kontaktierungsprozess für diese (Lötprozess).

Die Lötfahnen 118 werden z.B. gleichzeitig mit den Pins 113 durch das Selektivlötverfahren mit angelötet. Dabei ist auch die Ausformung der sichelförmigen bzw. banananenförmigen Steckerpins wieder von Vorteil für das Selektivlötverfahren, welches ermöglicht die Pins gleichzeitig mit dem Lötfinger reproduzierbar zu benetzen und dadurch eine sehr kurze Lötzeit zu realisieren, insbesondere weniger als 5s.

Bei der Elektronikplatine 108 sind in Fig. 1a einzelne Kontaktierungspads (steckerseitige Kontaktierungspads 116) auf der rechten Seite dargestellt. Über diese findet die Kontaktierung mit den Pins 113 statt.

Bei der Elektronikplatine 108 sind auch auf der linken Seite in Fig. 1a drei Kontaktierungspads (sensorseitige Kontaktierungspads 122) dargestellt, die beispielsweise mit nicht dargestellten Pins der Sensorplatine 109 in Kontakt sind.

Der Kontakt wird über ein Löten, insbesondere ein Selektivlöten vorgenommen.

Beispielsweise kann die Kontaktierung der Pins des Steckers mit den Kontaktierungspads der Elektronikplatine 108 und auch die Kontaktierung der Pins der Sensorplatine 109 mit den Kontaktierungspads der Elektronikplatine 108 jeweils in einem einzigen Lötschritt erfolgen zum Beispiel über eine Miniwelle, die über beziehungsweise durch den zu Lötenden Bereich gefahren wird, sodass die einzelnen Pins gleichzeitig selektiv gelötet werden. Während dieses Selektivlötschrittes des Lötens der Pins 113 können auch gleichzeitig die Lötfahnen 118 an den Massekontaktierungspads 120 angelötet werden.

Ein Selektiv-Lötverfahren zeichnet sich dadurch aus, dass selektiv die einzelnen Pins gelötet werden und nicht die Verbindung auf der gesamten Platine gleichzeitig gelötet wird.

Auch die Verbindung der Kontakte der Sensorplatine 109 mit den sensorseitigen Kontaktierungspads 122 kann in einem einzigen Selektivlötschritt erfolgen, der zusätzlich zu dem Selektivlötschritt zur Kontaktierung des Steckers durchgeführt wird.

Figuren 4b bis e zeigen Details zu der Verbindung zwischen Sensorplatine 109 und Elektronikplatine 108. In den Figuren 4b bis d ist nur ein Abschnitt der Elektronikplatine 108 dargestellt, sodass die in den Figuren 3c und 4a dargestellte Verbindung zu dem Stecker nicht zu sehen ist. Figur 4e zeigt schematisch die Kontaktierungspads an der Sensorplatine 109, diese sind dort mit Bezugszeichen 122 bezeichnet. Es sind insgesamt sechs solcher Kontaktierungspads 123 vorgesehen. Diese sind so angeordnet, dass diese bei Anordnung der Sensorplatine 109 senkrecht zur Elektronikplatine 108 direkt zu den entsprechenden sensorseitigen Kontaktierungspads 122 auf der Elektronikplatine 108 gegenüberliegend angeordnet sind.

So können dann auch die in den Figuren mit Bezugszeichen 124 bezeichneten Lötstellen nach Art einer Kehllötstelle hergestellt werden. Alle sechs Kehllötstellen vom Verbinden der Sensorplatine 109 mit der Elektronikplatine werden vorteilhafterweise in einem einzigen Selektivlötschritt hergestellt.

Insbesondere kann vorgesehen sein, dass pro Seite, das heißt auf der oberen und unteren Seite der Elektronikplatine, je drei Lötstellen angeordnet sind. Diese drei Lötstellen können vorteilhafterweise in einem einzigen Selektivlötschritt hergestellt werden, etwa durch gleichzeitiges Benetzen der drei Pads mit dem Lötfinger. Die andere Seite mit den drei Lötpads kann dann nach dem Wenden der Platine in einem zweiten Schritt gelötet werden. Insbesondere kann der Lötfinger nur von "unten" an die Lötenpads herfahren, um diese zu benetzten.

Allerding kann in einer weiteren Ausführung vorgesehen sein, wobei zwei gleichzeitig verwendete Lötfinger verwendet werden, um die eine Seite der Platine mit drei Lötstellen der Sensorplatine 109 mit der Elektronikplatine 108 und die Kontaktierung der Steckerpins 113 sowie die Lötfahne 118 mit der Elektronikplatine 108 gleichzeitig zu löten.

Nach dem Fügen durch Löten und Verbindung der Elemente und dann Umspritzen mit der gespritzten Hülle 110 wird dann die Frontkappe 109 über die Sensorplatine 108 gesteckt und die gesamte Baueinheit 105 und die Kappe 109 von der Frontseite in das Gehäuse 100 eingebracht.

Danach wird das Gehäuse rückseitig an dem verjüngten Ende, welches in Fig. 1c mit Bezugszeichen 114 versehen ist, gebördelt um eine verlierfeste Fixierung zu erreichen.

Soweit in dem speziellen Ausführungsbeispiel einzelne Merkmale gezeigt sind, sollen diese auch separat unter Schutz gestellt werden können und für sich eine Erfindung bilden.

Insbesondere können die sichelförmigen bzw. bananenförmigen Kontakte, und/oder die Anordnung der Pins 113, die die Elektronikplatine 108 bilden, für sich eine Erfindung bilden.

Insbesondere kann ferner das Selektivlöten, und/oder das Löten mittels Miniwelle, insbesondere in einem Schritt, für sich eine Erfindung bilden.

Die vorliegende Baugruppe wird z.B. vollautomatisch hergestellt, indem zuerst die Baueinheit 105 aus Elektronikplatine 108, Sensorplatine 109 und Stecker vorgefertigt wird aus den entsprechenden Einzelteilen. Es sind zum Beispiel lediglich je zwei Selektivlötschritte nötig, da beide Seiten der Elektronikplatine 108 jeweils drei Lötpads zur Kontaktierung der Sensorplatine 109 (vorderer Bereich) und drei Lötpads zur Kontaktierung des Steckers und Lötfahne aufweisen (hinterer Bereich der Platine). Dieses automatische Verfahren kann auch für sich eine Erfindung bilden.

### Bezugszeichenliste

- 1: Sensoreinheit
- 2: Schaltungsträger
- 3: Stecker
- 4: PU-Weichschaum
- 5: zylindrischen Abschnitt
- 6: Gewinderohr
- 7: Lochscheibe

- 100: Gehäuse
- 101: Frontöffnung
- 102: Bund
- 103: Rückseitenöffnung
- 104: Innenumfangsfläche
- 105: Baueinheit
- 106: Frontkappe
- 107: Stecker
- 108: Elektronikplatine
- 109: Sensorplatine
- 110: gespritzte Hülle
- 112: Steckergehäuse
- 113: Pin
- 114: verjüngtes Ende

- 116: steckerseitiges Kontaktierungspad
- 117: Blechring
- 118: Lötfahnen
- 119: Einpressfahnen
- 120: Massekontaktierungspad
- 121: Kondensator
- 122: sensorseitiges Kontaktierungspad
- 123: Kontaktierungspad der Sensorplatine
- 124: Lötstelle

## Patentansprüche

1. Elektronische Baugruppe mit einem Gehäuse (100), einem Stecker (107), einer
Elektronikplatine (108), einer Sensorplatine (109) und einer Frontkappe (106); wobei
das Gehäuse (100) von einer Rückseite zu einer Frontseite nacheinander den Stecker (107), die Elektronikplatine (108), die Sensorplatine (109) und die Frontkappe (106) aufnimmt; wobei
an der Rückseite des Gehäuses (100) ein Bund (102) vorgesehen ist, an dem sich eine axiale Endfläche des Steckers (107) abstützt, sodass der Stecker (107) nicht aus der Rückseite des Gehäuses (100) herausgezogen werden kann; wobei
der Stecker (107), die Elektronikplatine (108), und die Sensorplatine (109) eine zusammengesetzte Baueinheit bildet, welche konfiguriert ist als Ganzes in das Gehäuse von der Frontseite eingeschoben zu werden und nach dem Einschieben von der Frontseite mit dem Bund (102) Wechsel zu wirken, sodass der Stecker (107) nicht aus der Rückseite des Gehäuses herausgezogen werden kann; und wobei
die Front des Gehäuses (100) mittels Bördeln um die Frontkappe (106) die Baueinheit in dem Gehäuse (100) fixiert und gegen den Bund (102) drückt.

2. Elektronische Baugruppe nach Anspruch 1, **dadurch gekennzeichnet, dass** der Stecker (107) ein Steckergehäuse (112) und Steckerpins (113) aufweist, welche in dem Steckergehäuse (112) gehalten sind, und das rückseitige Ende der Pins (113), mittels welchem eine Kontaktierung mit einem ersten Ende der Elektronikplatine (108) erfolgt, sichelförmig ausgebildet sind, wobei insbesondere die Steckerpins (113) jeweils so in dem Steckergehäuse (112) angeordnet sind, dass sich die sichelförmigen Enden einander gegenüberliegen und deren Ausbuchtungen die Elektronikplatine an den entsprechenden Kontaktierungspads zwischen sich auflegen und diese vorfixieren.

3. Elektronische Baugruppe nach Anspruch 2, **dadurch gekennzeichnet, dass** ein Erdungselement vorgesehen ist, welches zwischen der Elektronikplatine (108) und dem Gehäuse (100) an einem elektronikplatinenseitigen Ende des Steckergehäuses (112) vorgesehen ist.

4. Elektronische Baugruppe nach Anspruch 3, **dadurch gekennzeichnet, dass** das Erdungselement durch einen Blechring (117) gebildet ist, der zumindest eine Lötfahne (118) zur Kontaktierung eines Massekontaktpads (120) der Elektronikplatine (108) aufweist, welches Kontaktpad mit einem Kondensator (121) auf der Elektronikplatine 108) verbunden ist, und wobei der Blechring (117) zumindest eine davon abstehende Einpressfahne (119) aufweist, die eine elektrisch leitende Kontaktierung zum Gehäuse (100) herstellt ,

5. Elektronische Baugruppe nach einem der vorherigen Ansprüche, **dadurch gekennzeichnet, dass** die Baueinheit ganz oder wenigstens teilweise von einer gespritzten Hülle (110) aus thermoplastischem Kunststoff umgeben wird, deren Kontur einen radialen Pufferbereich für die Wärmeausdehnung zum Gehäuse freilässt , wobei insbesondere die gespritzte Hülle (110) mittels Niederdruckspritzgussverfahrens hergestellt ist, wobei die Baueinheit mit der gespritzten Hülle (110) eine Einheit bildet, welche lediglich durch die gebördelte Frontseite des Gehäuses (100) und den Bund (102) an der Rückseite des Gehäuses (100) gehalten wird.

6. Elektronische Baugruppe nach einem der vorherigen Ansprüche, **dadurch gekennzeichnet, dass** es sich bei dem elektronischen Bauteil um einen der folgenden Sensortypen handelt: Näherungsschalter, induktiver Sensor, kapazitiver Sensor, Drucksensor, Gassensor, Temperatursensor, Feuchtigkeitssensor, Ultraschallsensor, Vibrationserkennungssensor, UV-sensor.

7. Verfahren zur Herstellung einer elektronischen Baugruppe, mit einem Gehäuse (100), einem Stecker (107), einer Elektronikplatine (108), einer Sensorplatine (109) und einer Frontkappe (106), wobei das Verfahren folgende Schritte enthält:
Kontaktieren von rückseitigen Enden von Pins (113), des Steckers (107) mit einem ersten Ende der Elektronikplatine (108);
Kontaktieren von Kontakten der Sensorplatine (109) mit entsprechenden Kontakten der Elektronikplatine (108) an einem zweiten Ende der Elektronikplatine (108);
sodass der Stecker (107), die Elektronikplatine (108), und die Sensorplatine (109) eine zusammengesetzte Baueinheit bilden;
Einführen der Baueinheit in das Gehäuse (100) von einer Frontseite zu einer Rückseite desselben bis dass sich eine axiale Endfläche des Steckers (107) an einem Bund (102) an der Rückseite des Gehäuses (100) abstützt;
Verschließen des Gehäuses (100) an der Frontseite mit der Frontkappe (106); und
Bördeln der Frontseite des Gehäuses (100) um die Frontkappe (106), sodass die Baueinheit in dem Gehäuse (100) fixiert ist und gegen den Bund (102) gedrückt wird.

8. Verfahren nach Anspruch 7, **dadurch gekennzeichnet, dass** das Verfahren des Weiteren einen Schritt des Umspritzens zumindest von Teilen der Baueinheit aufweist, sodass die Baueinheit ganz oder wenigstens teilweise von einer gespritzten Hülle (110) umgeben wird.

9. Verfahren nach Anspruch 7 oder 8, **dadurch gekennzeichnet, dass** das Kontaktieren der rückseitigen Enden der Pins (113) des Steckers (107) mit dem ersten Ende der Elektronikplatine (108); und/oder
das Kontaktieren der Kontakte der Sensorplatine (109) mit den entsprechenden Kontakten der Elektronikplatine (108) an dem zweiten Ende der Elektronikplatine (108), mittels eines Selektivlötprozesses und/oder Wellenlötprozesses erfolgt, wobei insbesondere alle Kontakte zwischen dem Stecker (108) und der Elektronikplatine (108) in einem einzigen ununterbrochenen Lötschritt durchgeführt werden, und/oder alle Kontakte zwischen der Sensorplatine (109) und der Elektronikplatine (108) in einem einzigen weiteren ununterbrochenem Lötschritt durchgeführt werden;
wobei insbesondere mit zwei gleichzeitig verwendeten Lötfingern die eine Seite der Platine mit den Lötstellen der Sensorplatine (109) mit der Elektronikplatine (108) und die Kontaktierung der Steckerpins (113) sowie die Lötfahne (118) mit der Elektronikplatine (108) gleichzeitig gelötet werden.

10. Verfahren nach einem der Ansprüche 7 bis 9, **dadurch gekennzeichnet, dass** das Verfahren automatisiert durchgeführt wird und die einzelnen Schritte insbesondere nicht händisch durchgeführt werden.

## Claims

1. Electronic assembly with a housing (100), a plug (107), an electronics board (108), a sensor board (109), and a front cap (106); wherein
the housing (100) receives, from a rear side to a front side, in succession the plug (107), the electronics board (108), the sensor board (109), and the front cap (106); wherein
a collar (102), on which an axial end face of the plug (107) is supported, is provided at the rear side of the housing (100) such that the plug (107) cannot be pulled out from the rear side of the housing (100); wherein
the plug (107), the electronics board (108), and the sensor board (109) form an assembled structural unit which is configured to be pushed as a whole from the front side into the housing and, after it has been pushed in from the front side, to interact with the collar (102) such that the plug (107) cannot be pulled out from the rear side of the housing; and wherein
the front of the housing (100) fixes the structural unit in the housing (100) by means of crimping around the front cap (106) and presses it against the collar (102).

2. Electronic assembly according to Claim 1, **characterized in that** the plug (107) has a plug housing (112) and plug pins (113) which are held in the plug housing (112), and the rear-side end of the pins (113), by means of which there is contact with a first end of the electronics board (108), is designed as crescent-shaped, wherein in particular the plug pins (113) are in each case arranged in the plug housing (112) such that the crescent-shaped ends are situated opposite one another and their bulges are applied between them against the electronics board at the corresponding contacting pads and pre-fix them.

3. Electronic assembly according to Claim 2, **characterized in that** a grounding element is provided which is provided between the electronics board (108) and the housing (100) at an end of the plug housing (112) at which the electronics board is situated.

4. Electronic assembly according to Claim 3, **characterized in that** the grounding element is formed by a sheet-metal ring (117) which has at least one soldering lug (118) for contacting a ground contact pad (120) of the electronics board (108), which contact pad is connected to a capacitor (121) on the electronics board (108), and wherein the sheet-metal ring (117) has at least one press-fit lug (119) protruding therefrom which establishes an electrically conductive contact with the housing (100).

5. Electronic assembly according to one of the preceding claims, **characterized in that** the structural unit is entirely or at least partially surrounded by an injection-moulded sleeve (110) made from thermoplastic, the contour of which leaves free a radial buffer region for the thermal expansion relative to the housing, wherein in particular the injection-moulded sleeve (110) is produced by means of a low-pressure injection-moulding method, wherein the structural unit forms a unit with the injection-moulded sleeve (110) which is held only by the crimped front side of the housing (100) and the collar (102) at the rear side of the housing (100).

6. Electronic assembly according to one of the preceding claims, **characterized in that** the electronic structural unit is one of the following types of sensor: a proximity sensor, an inductive sensor, a capacitive sensor, a pressure sensor, a gas sensor, a temperature sensor, a moisture sensor, an ultrasound sensor, a vibration detection sensor, a UV sensor.

7. Method for producing an electronic assembly with a housing (100), a plug (107), an electronics board (108), a sensor board (109), and a front cap (106), wherein the method contains the following steps:
contacting rear-side ends of pins (113), of the plug (107) with a first end of the electronics board (108);
contacting contacts of the sensor board (109) with corresponding contacts of the electronics board (108) at a second end of the electronics board (108);
such that the plug (107), the electronics board (108), and the sensor board (109) form an assembled structural unit;
inserting the structural unit into the housing (100) from a front side toward a rear side of the housing until an axial end face of the plug (107) is supported on a collar (102) at the rear side of the housing (100);
closing the housing (100) at the front side with the front cap (106); and
crimping the front side of the housing (100) around the front cap (106) such that the structural unit is fixed in the housing (100) and is pressed against the collar (102).

8. Method according to Claim 7, **characterized in that** the method furthermore has a step of injection-overmoulding at least parts of the structural unit such that the structural unit is entirely or at least partially surrounded by an injection-moulded sleeve (110).

9. Method according to Claim 7 or 8, **characterized in that** the contacting of the rear-side ends of the pins (113) of the plug (107) with the first end of the electronics board (108); and/or
the contacting of the contacts of the sensor board (109) with the corresponding contacts of the electronics board (108) at the second end of the electronics board (108) are effected by means of a selective soldering process and/or wave soldering process, wherein in particular all the contacts between the plug (108) and the electronics board (108) are made in a single uninterrupted soldering step, and/or all the contacts between the sensor board (109) and the electronics board (108) are made in a single further uninterrupted soldering step;
wherein, in particular with two simultaneously used soldering fingers, simultaneously one side of the board is soldered with the solder points of the sensor board (109) to the electronics board (108) and the contacting of the plug pins (113), as well as the soldering lug (118), with the electronics board (108) is soldered.

10. Method according to one of Claims 7 to 9, **characterized in that** the method is performed in an automated manner and the individual steps are in particular not performed manually.

## Revendications

1. Module électronique comprenant un boîtier (100), une fiche (107), une carte électronique (108), une carte de détection (109) et un capuchon avant (106) ;
le boîtier (100) accueillant la fiche (107), la carte électronique (108), la carte de détection (109) et le capuchon avant (106), successivement d'un côté arrière à un côté avant ;
un épaulement (102) étant prévu au niveau du côté arrière du boîtier (100), sur lequel s'appuie une face d'extrémité axiale de la fiche (107), de sorte que la fiche (107) ne peut pas être retirée du côté arrière du boîtier (100) ;
la fiche (107), la carte électronique (108) et la carte de détection (109) formant une unité structurelle assemblée, laquelle est configurée pour être insérée en tant qu'ensemble dans le boîtier par le côté avant et, après l'insertion par le côté avant, pour interagir avec l'épaulement (102), de sorte que la fiche (107) ne peut pas être retirée du côté arrière du boîtier ; et
l'avant du boîtier (100) calant l'unité structurelle dans le boîtier (100) au moyen du rabattement du bord autour du capuchon avant (106) et la pressant contre l'épaulement (102).

2. Module électronique selon la revendication 1, **caractérisé en ce que** la fiche (107) possède un boîtier de fiche (112) et des broches de fiche (113), lesquelles sont maintenues dans le boîtier de fiche (112), et l'extrémité arrière des broches (113), au moyen desquelles s'effectue une mise en contact avec une première extrémité de la carte électronique (108), est réalisée en forme de faucille, les broches de fiche (113) étant en particulier respectivement disposées dans le boîtier de fiche (112) de telle sorte que les extrémités en forme de faucille se font mutuellement face et leurs renflements font reposer la carte électronique sur les pastilles de contact correspondantes entre elles et précalent celle-ci.

3. Module électronique selon la revendication 2, **caractérisé en ce qu'**un élément de mise à la terre est prévu, lequel est prévu entre la carte électronique (108) et le boîtier (100) au niveau d'une extrémité du boîtier de fiche (112) située du côté de la carte électronique.

4. Module électronique selon la revendication 3, **caractérisé en ce que** l'élément de mise à la terre est formé par une bague en tôle (117) qui présente au moins une cosse de soudage (118) destinée à la mise en contact d'une pastille de contact de masse (120) de la carte électronique (108), laquelle pastille de contact est reliée à un condensateur (121) sur la carte électronique (108), et la bague en tôle (117) possédant au moins une cosse d'enfoncement (119) qui fait saillie de celle-ci et qui établit un contact électriquement conducteur avec le boîtier (100).

5. Module électronique selon l'une des revendications précédentes, **caractérisé en ce que** l'unité structurelle est entourée complètement ou au moins partiellement par une enveloppe (110) moulée par injection en matière thermoplastique, dont le contour laisse dégagée une zone tampon radiale pour la dilatation thermique vers le boîtier, l'enveloppe (110) moulée par injection étant en particulier fabriquée au moyen d'un procédé de moulage par injection à basse pression, l'unité structurelle formant avec l'enveloppe (110) moulée par injection une unité, laquelle est maintenue au niveau du côté arrière du boîtier (100) uniquement par le côté avant au bord rabattu du boîtier (100) et l'épaulement (102).

6. Module électronique selon l'une des revendications précédentes, **caractérisé en ce que** le composant électronique est l'un des types de capteurs suivants : détecteur de proximité, capteur inductif, capteur capacitif, capteur de pression, capteur de gaz, capteur de température, capteur d'humidité, capteur ultrasonique, capteur de reconnaissance de vibrations, capteur d'UV.

7. Procédé de fabrication d'un module électronique, comprenant un boîtier (100), une fiche (107), une carte électronique (108), une carte de détection (109) et un capuchon avant (106), le procédé comprenant les étapes suivantes :
mise en contact des extrémités arrière de broches (113), de la fiche (107) avec une première extrémité de la carte électronique (108) ;
mise en contact des contacts de la carte de détection (109) avec des contacts correspondants de la carte électronique (108) à une deuxième extrémité de la carte électronique (108) ;
de telle sorte que la fiche (107), la carte électronique (108) et la carte de détection (109) forment une unité structurelle assemblée ;
insertion de l'unité structurelle dans le boîtier (100) d'un côté avant vers un côté arrière de celui-ci jusqu'à ce qu'une face d'extrémité axiale de la fiche (107) s'appuie sur un épaulement (102) au niveau du côté arrière du boîtier (100) ;
fermeture du boîtier (100) au niveau du côté avant avec le capuchon avant (106) ; et
rabattement du bord du côté avant du boîtier (100) autour du capuchon avant (106) de sorte que l'unité structurelle soit calée dans le boîtier (100) et pressée contre l'épaulement (102).

8. Procédé selon la revendication 7, **caractérisé en ce que** le procédé comprend en outre une étape de surmoulage d'au moins des parties de l'unité structurelle, de telle sorte que l'unité structurelle soit complètement ou au moins partiellement entourée par une enveloppe moulée par injection (110).

9. Procédé selon la revendication 7 ou 8, **caractérisé en ce que** la mise en contact des extrémités arrière des broches (113) de la fiche (107) avec la première extrémité de la carte électronique (108) ; et/ou
la mise en contact des contacts de la carte de détection (109) avec les contacts correspondants de la carte électronique (108) au niveau de la deuxième extrémité de la carte électronique (108) s'effectue au moyen d'un procédé de soudage sélectif et/ou d'un procédé de soudage à la vague, tous les contacts entre la fiche (108) et la carte électronique (108) étant notamment réalisés en une seule étape de soudage ininterrompue et/ou tous les contacts entre la carte de détection (109) et la carte électronique (108) étant réalisés en une seule étape de soudage ininterrompue supplémentaire ;
le côté de la carte qui comporte les points de soudage de la carte de détection (109) avec la carte électronique (108) et la mise en contact des broches de fiche (113) ainsi que des cosses de soudage (118) avec la carte électronique (108) étant soudés simultanément, notamment avec deux doigts de soudage utilisés simultanément.

10. Procédé selon l'une des revendications 7 à 9, **caractérisé en ce que** le procédé est mis en œuvre de manière automatisée et les étapes individuelles ne sont notamment pas exécutées manuellement.
